# EUROPEAN PATENT SPECIFICATION

(11) **EP 3 570 048 B1**
(45) Date of publication and mention of the grant of the patent: **15.07.2026**
(21) Application number: 17891144.2
(22) Date of filing: 19.10.2017
(51) Int. Cl.: G01R 22/06, G01R 11/24, H02H 5/04, H02J 13/00, G01R 22/10, H02J 13/12, H02J 3/001

(54) **CAUSE DETERMINATION DEVICE, POWER AMOUNT MANAGEMENT SYSTEM AND CAUSE DETERMINATION METHOD**
VORRICHTUNG ZUR URSACHENBESTIMMUNG, SYSTEM ZUR VERWALTUNG DER LEISTUNGSMENGE UND VERFAHREN ZUR URSACHENBESTIMMUNG
DISPOSITIF DE DÉTERMINATION DE CAUSE, SYSTÈME DE GESTION DE QUANTITÉ D'ÉNERGIE ET PROCÉDÉ DE DÉTERMINATION DE CAUSE

(30) Priority: 13.01.2017 JP 2017004079
(43) Date of publication of application: 20.11.2019
(73) Proprietor: Omron Corporation, Kyoto-shi, Kyoto 600-8530 (JP)
(72) Inventor: SATO, Masashi, Ichinomiya-shi Aichi 491-0201 (JP)
(74) Representative: Kilian Kilian & Partner mbB
(86) International application number: PCT/JP2017/037897
(87) International publication number: WO 2018/131246

(56) References cited:
- CN-U- 203 164 248
- CN-U- 203 164 248
- JP-A- 2010 019 680
- JP-A- 2010 019 680
- JP-A- 2014 155 385
- KR-B1- 101 201 955
- US-A1- 2002 105 435
- US-A1- 2005 184 867
- US-A1- 2010 036 624
- US-A1- 2010 036 625
- US-A1- 2015 070 507

## Description

### Technical Field

The present invention relates to a cause determination device for determining a cause of an abnormality of an energy meter, a power amount management system, and a cause determination method.

### Background Art

Conventionally, there have been wrongdoers who commit electricity theft (steal electricity) by tampering with energy meters. Various techniques have been proposed for preventing such electricity theft. For example, Patent Literature 1 discloses a technology that allows an abnormality to be reported upon detection of loosening of a sealing screw for fixing a cover for an energy meter to the energy meter.

However, although the technology disclosed in Patent Literature 1 allows a fraudulent activity that involves opening of a cover of an energy meter (e.g., formation of a fraudulent bypass wiring line) to be detected, it is still difficult according to the technology to detect a fraudulent activity that does not involve opening of such a cover.

Among fraudulent activities not involving opening of a cover, fraudulent activities targeting digital energy meters called smart meters (described below) are recently attracting attention as a great threat.

A smart meter is used to digitally measure and output (e.g., display or transmit) an amount of electric power and includes a processor, a display section, and an external communication section realized by, for example, an optical port for infrared communications. A processor in the smart meter measures an electric power amount supplied to a supply destination on the basis of a current sensor or the like, displays the electric power amount by controlling the display section, and transmits the electric power amount to an external device by controlling the external communication section.

As a result, the processor which controls the display section and the external communication section in the smart meter transmits and receives a signal to and from the display section or the external communication section.

Here, the display section and the external communication section in the smart meter needs to be viewable from the outside, and are therefore not protected by an electromagnetic shield. Therefore, although the processor itself in the smart meter is protected by the electromagnetic shield, the processor has a less protection against the emission of radio waves or an electrostatic discharge (ESD) due to the need to perform signal communications with a display section or an external communication section that have a wide surface area and that are not protected by the electromagnetic shield.

Here, some wrongdoers commit a fraudulent activity involving temporarily creating radio wave emissions or an electrostatic discharge that causes the processor in the smart meter to hang. While the processor in a smart meter hangs, an electric power amount is not measured even if electricity is supplied, and a wrongdoer can steal electricity, accordingly. The wrongdoer leaves little trace of the fraudulent activity by (i) causing the processor to hang by creating radio wave emissions or an electrostatic discharge for only a short period of time and (ii) letting the processor normally operate without creating radio wave emissions or an electrostatic discharge in the other periods.

For this reason, the fraudulent activities by creating radio wave emissions or an electrostatic discharge are viewed as a great threat.

In this connection, Patent Literature 2 discloses a technique for providing an energy meter capable of detecting a fraudulent activity carried out on an ammeter by creating radio wave emissions or an electrostatic discharge.

Document US 2005/0184867 A1 discloses an energy monitoring and controlling system comprising, in one embodiment, a temperature sensor configured to communicate with an intelligent controller.

Documents US 2015/0070507 A1, JP 2010 019680 A, US 2010/036624 A1 and US 2002/105435 A1 each disclose an energy meter being provided with two temperature sensors.

### Citation List

### [Patent Literature]

[Patent Literature 1]
   JP. 2002-257 862 A (Publication Date: September 1, 2002)
[Patent Literature 2]
   WO 2016/143 042 A1 (Publication Date: September 15, 2016)

### Summary of Invention

### Technical Problem

Electricity theft through tampering with an energy meter by a method other than the creation of radio wave emissions or an electrostatic discharge is committed by, for example, setting fire to the energy meter so as to delete a record of power consumption for which a user should be charged. In this case, power supply companies file claims for damages against those who have committed the fraud by setting fire to the energy meter, i.e., those who have committed the electricity theft by setting fire to the energy meter.

With conventional energy meters, however, it is not possible to file claims for damages due to lack of evidence of the fraud.

In many cases of electricity theft by setting fire, in particular, wrongdoers make such false accusation that the energy meters caught fire from inside due to malfunction.

It is an object of an aspect of the present invention to improve accuracy of determination of a cause of occurrence of an abnormality of an energy meter.

### Solution to Problem

The present invention is directed to a device enabling the determination of a cause of a fire according to claim 1, to a power amount management system according to claim 4 and to a method enabling the determination of a cause of a fire according to claim 5. Embodiments of the invention are described in the dependent claims.

### Advantageous Effects of Invention

With an aspect of the present invention, it is possible to determine a cause of an abnormality accurately.

### Brief Description of Drawings

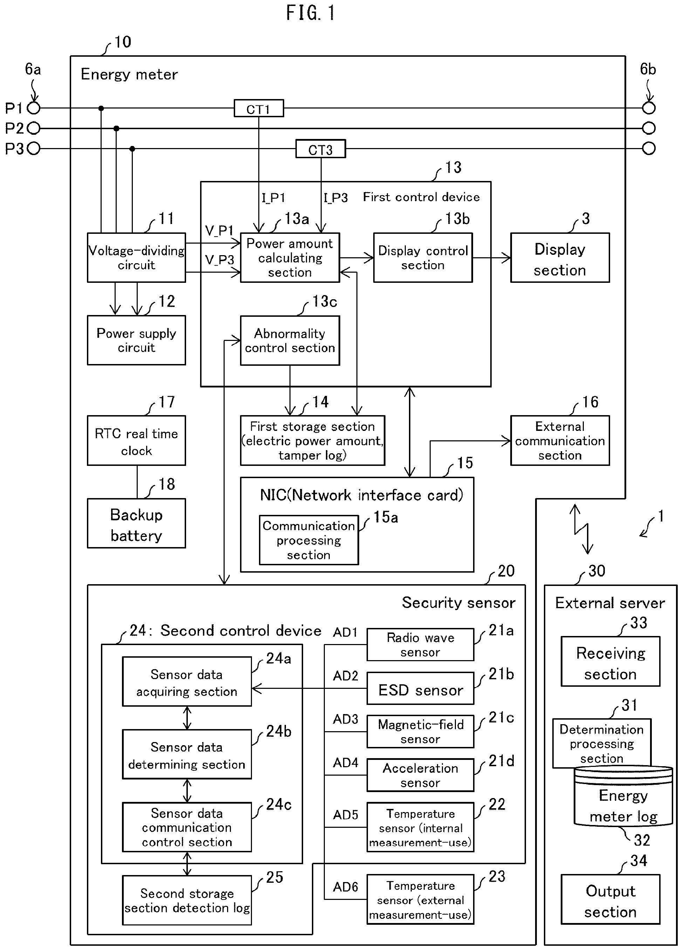

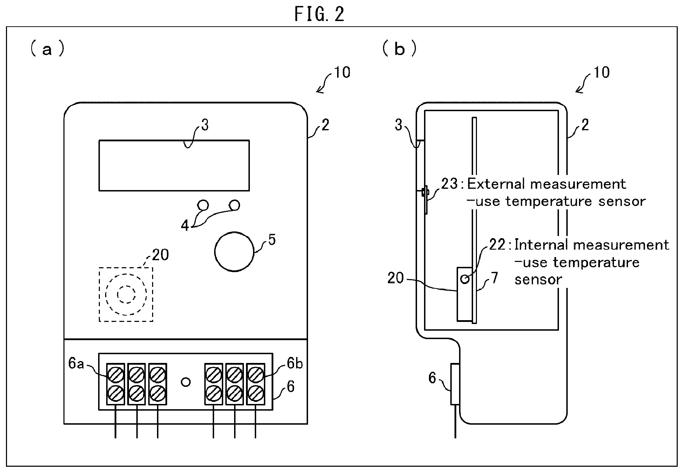

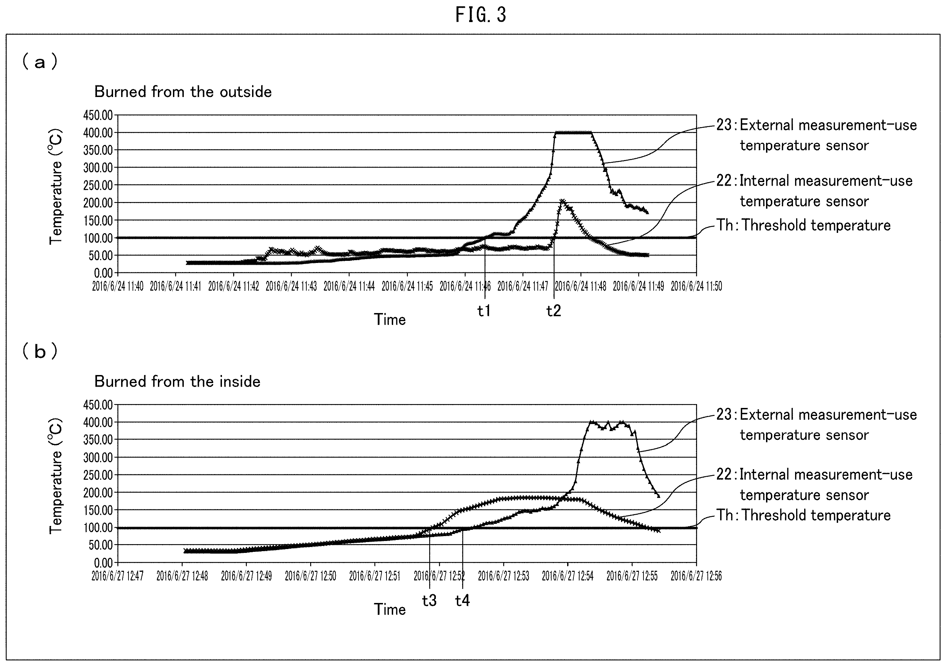

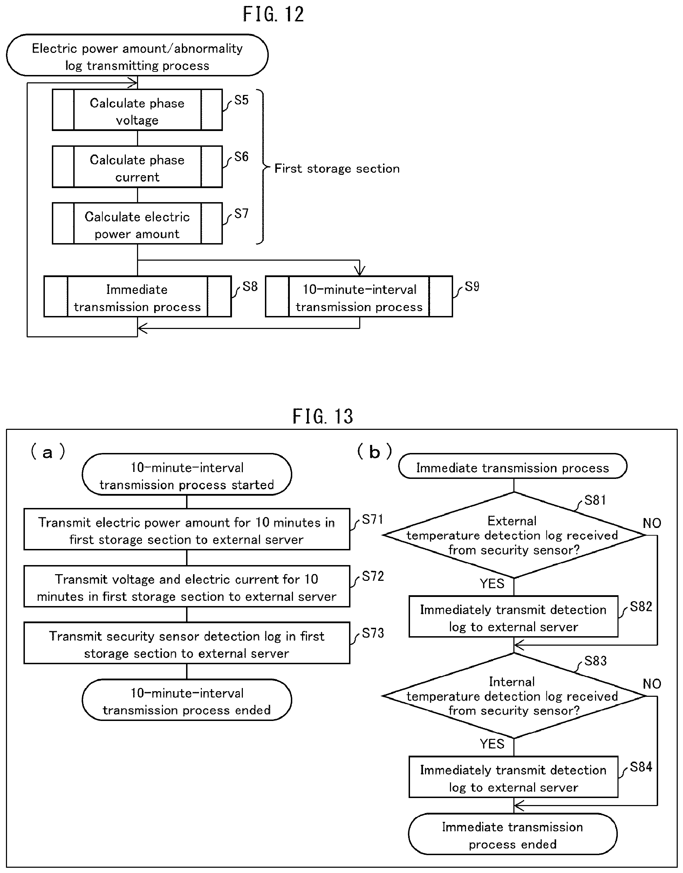

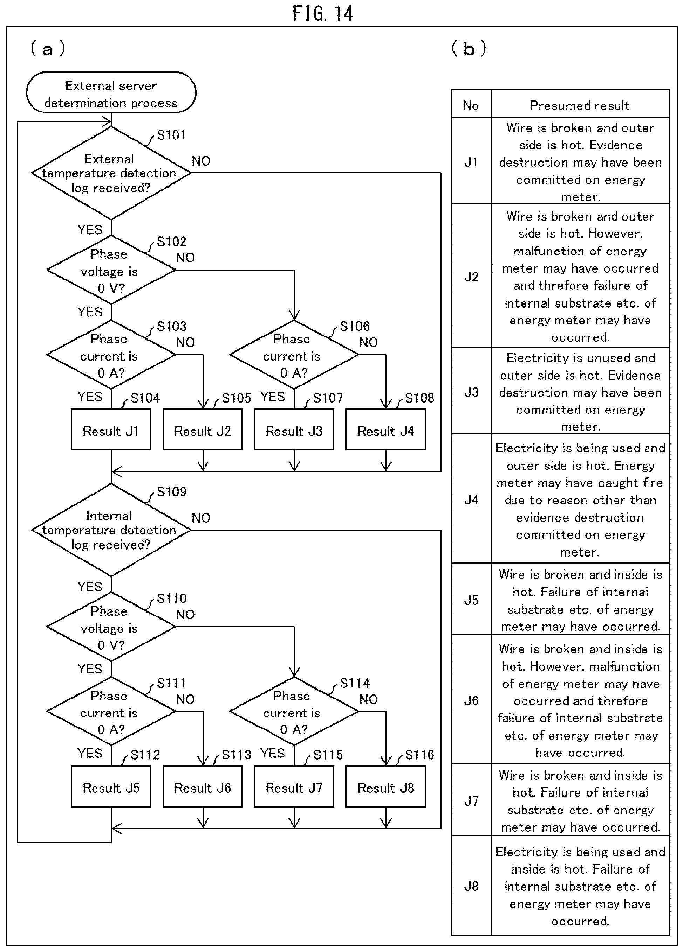

Fig. 1 is a block diagram illustrating a configuration of a power amount management system in accordance with an embodiment of the present invention.
(a) of Fig. 2 is an elevational view illustrating an external configuration of an energy meter in the power amount management system, and (b) of Fig. 2 is a lateral cross-sectional view illustrating a configuration of the energy meter.
(a) of Fig. 3 is a graph showing temperature changes in internal and external temperatures in a case where the energy meter has been burned from outside the energy meter. (b) of Fig. 3 is a graph showing temperature changes in internal and external temperatures in a case where fire has broken out from inside the energy meter.
Fig. 4 is a view showing a list of data stored in the first storage section of the energy meter.
Fig. 5 is a view showing a list of data stored in an external server in the power amount management system.
Fig. 6 is a view showing evaluation criteria in accordance with which a determination processing section of the external server determines a fraud in a case where an external temperature of the energy meter has exceeded a threshold temperature and in a case where an internal temperature of the energy meter has exceeded a threshold temperature.
Fig. 7 is a flowchart of a main routine indicative of an operation process of a security sensor of the energy meter.
Fig. 8 is a flowchart of a sub-routine indicative of a sensor initialization operation of the security sensor of the energy meter.
Fig. 9 is a flowchart of a sub-routine indicative of a sensor process operation of the security sensor of the energy meter.
Fig. 10 is a flowchart of a sub-routine indicative of a continuation of the sensor process operation of the security sensor.
Fig. 11 is a flowchart of a sub-routine indicative of a continuation of the sensor process operation of the security sensor.
Fig. 12 is a flowchart of a main routine indicative of an electric power amount/abnormality log transmitting process operation of the energy meter.
(a) of Fig. 13 is a flowchart of a sub-routine indicative of a 10-minute-interval transmission process carried out by the energy meter to transmit an electric power amount and an abnormality log, and (b) of Fig. 13 is a flowchart of a sub-routine indicative of an immediate transmission process operation carried out by the energy meter to transmit an electric power amount and an abnormality log.
(a) of Fig. 14 is a flowchart showing a determination process carried out by the external server, and (b) of Fig. 14 is a view showing presumed results.

### Description of Embodiments

The following will describe an embodiment of the present invention with reference to Figs. 1 to 14.

A power amount management system in accordance with the present embodiment includes an energy meter and an external server. That is, the energy meter in accordance with the present embodiment is a so-called smart meter. The smart meter is a next-generation energy meter that digitally measures electric power and includes a communication capability inside the meter, unlike the conventional analog induction type energy meter. A power amount management system in accordance with the present embodiment is a system as a whole in which an electric power amount appropriately transmitted from the energy meter is managed by the external server. The conventional energy meter, for example, measures the total amount of one-month power consumption by monthly meter reading, whereas the smart meter, for example, transmits the amount of power consumption to an administrator every 15 minutes to 30 minutes on a daily basis. Thus, the smart meter has the advantage of eliminating the need for a meter reader to perform a meter reading work.

### [Configuration of power amount management system]

Fig. 1 is a block diagram illustrating a configuration of a power amount management system 1 in accordance with the present embodiment. (a) of Fig. 2 is an elevational view illustrating an external configuration of an energy meter 10 in the power amount management system 1, and (b) of Fig. 2 is a lateral cross-sectional view illustrating the configuration of the energy meter 10.

As illustrated in Fig. 1, the power amount management system 1 in accordance with the present embodiment is a system in which an electric power amount periodically transmitted from the energy meter 10 is managed by an external server 30, and the system includes the energy meter 10 and the external server 30.

As illustrated in (a) and (b) of Fig. 2, the energy meter 10 includes a housing 2 which has, for example, a substantially rectangular shape and is made out of, for example, a resin product. The housing 2 has a display section 3, two light emitting diode (LED) lamps 4, and a data extraction terminal 5 provided in an upper part on the front side thereof. The housing 2 also has a terminal board 6 provided in a lower part on the front side thereof. In the housing 2, a security sensor 20 is fixed to a circuit board 7 and includes an internal measurement-use temperature sensor 22 serving as an internal temperature detection sensor. On a back side of the display section 3, an external measurement-use temperature sensor 23 is provided as an external temperature detection sensor.

The display section 3 is realized by a liquid crystal display (LCD) device and is configured to display the amount of power consumption.

One of the two LED lamps 4 illuminates during operation of the energy meter 10 to indicate that the energy meter 10 is in operation. Another one of the LED lamps 4 is a lamp which flashes quickly as the amount of power consumption increases to indicate a rate at which the amount of power consumption increases.

In the present embodiment, the terminal board 6 is provided with, for example, three input terminals 6a and three output terminals 6b. The input terminals 6a are connected to, for example, transmission lines from a utility pole outside a building. On the other hand, the output terminals 6b are connected to wiring lines to the inside of a building. In the present embodiment, the terminal board 6 is a terminal board in a three-phase AC system. However, the terminal board 6 is not necessarily limited to such a terminal board. Alternatively, the terminal board 6 may be a terminal board in a two-phase AC system.

As illustrated in Fig. 1, the energy meter 10 in accordance with the present embodiment digitally measures the amount of electric power supplied to, for example, a home or the like through transmission lines P1 to P3 in a three-phase AC system.

The energy meter 10 includes current sensors (current transformers) CT1 and CT3, a voltage-dividing circuit 11, a power supply circuit 12, a first control device 13, the display section 3, a first storage section 14 serving as a transmitting section, a network interface card (NIC) 15, an external communication section 16 serving as a transmitting section, a real time clock (RTC) 17, a backup battery 18, and the security sensor 20.

The current sensor CT1 detects an electric current value I_P1 in the transmission line P1, and the current sensor CT3 detects an electric current value I_P3 in the transmission line P3.

The voltage-dividing circuit 11 detects a voltage value V_P1 in the transmission line P1 and a voltage value V_P3 in the transmission line P3, and transmits data of the voltage value V_P1 and voltage value V_P3 to a power amount calculating section 13a of the first control device 13 (described later).

The power supply circuit 12 supplies electric power to hardware included in the energy meter 10.

The display section 3 is a display device which is electrically connected directly to the first control device 13 and is controlled by the first control device 13 to display power consumption. The display section 3 is attached to the housing 2 so as to be visible from outside the energy meter 10. This allows a consumer to view the information displayed on the display section 3.

The first control device 13 is provided on a control circuit board for controlling the hardware in the energy meter 10, specifically including a processor (for example, a central processing unit, CPU) for executing a program.

The first storage section 14 serves as a storage area for storing information, and employs, for example, an electrically erasable programmable read-only memory (EEPROM) (Registered Trademark) in the present embodiment. The first storage section 14 stores the amount of power calculated by the power amount calculating section 13a (described later) and an abnormality log extracted by an abnormality control section 13c. The first control device 13 performs reading/writing of information from/to the first storage section 14.

The network interface card (NIC) 15 is a card-type extension unit for connecting a computer to a communications network (LAN), and includes a communication processing section 15a.

The external communication section 16 serves as a communication port for communicating with the external server 30, which is a terminal device at an electric power company, through a communication network (not illustrated). The communication network may be a radio communication network (for example, wireless LAN) or may be a wired communication network such as, for example, power line communication (PLC).

The first control device 13 includes the power amount calculating section 13a, a display control section 13b, and the abnormality control section 13c. Although the first control device 13 is constituted by hardware, the power amount calculating section 13a, the display control section 13b, and the abnormality control section 13c, which are included in the first control device 13, are each a functional block representing the software functions executed by the first control device 13.

Every time, for example, notification of power consumption is requested by the external server 30, the first control device 13 calculates power consumption using the power amount calculating section 13a and controls the external communication section 16 to transmit the power consumption to the external server 30 of the electric power company which is an administrator. However, the present embodiment is not necessarily limited to this, and the energy meter 10 may configured to automatically and periodically transmit the power consumption to the external server 30.

The power amount calculating section 13a represents a function block for calculating (measuring) the amount of electric power supplied to a house through the transmission lines P1 to P3 (i.e., the power consumption of a power supply target) using detection values from the current sensors CT1 and CT3 and the voltage-dividing circuit 11.

Specifically, the power amount calculating section 13a calculates an instantaneous power value in the transmission line P1 by multiplying the electric current value IP_1 by the voltage value V_P1 and calculates an instantaneous power value in the transmission line P3 by multiplying the electric current value I_P3 by the voltage value V_P3. Then, the power amount calculating section 13a calculates a first power consumption for a first prescribed period (for example, a few seconds) by time-integrating the sum of the instantaneous power value in the transmission line P1 and the instantaneous power value in the transmission line P3.

Further, the power amount calculating section 13a calculates a second power consumption for every second prescribed period (e.g., 10 minutes in the present embodiment) which is longer than the first prescribed period, and stores the second power consumption in the first storage section 14.

Note that the power amount calculating section 13a does not necessarily calculate the first power consumption for every few seconds or the second power consumption for every 10 minutes. For example, the power amount calculating section 13a may calculate the power consumption for every day or for every month and store the calculated power consumption in the first storage section 14.

The display control section 13b represents a block for controlling the display section 3. The display control section 13b acquires the first power consumption from the power amount calculating section 13a every time the power amount calculating section 13a calculates, for example, the first power consumption, and causes the first power consumption to be displayed on the display section 3.

Further, the display control section 13b may cause any one of the second power consumption for 10 minutes, daily power, and monthly power stored in the first storage section 14 to be displayed on the display section 3 in response to the input of an external command (a command from an operator).

The abnormality determination control section 13c acquires an abnormality log (detailed later) generated by the security sensor 20 from the security sensor 20 and stores the abnormality log in the first storage section 14.

Specifically, a sensor data determining section 24b (described later) in the security sensor 20 determines that a temperature detected by the internal measurement-use temperature sensor 22 or a temperature detected by the external measurement-use temperature sensor 23 has reached a corresponding one of threshold temperatures Th that were set in advance as a first threshold temperature and a second threshold temperature, respectively. Every time such a determination is made by the sensor data determining section 24b, a result of the determination is transmitted to the abnormality control section 13c.

The abnormality determination control section 13c determines which one of the internal temperature and the external temperature has reached the threshold temperature Th first on the basis of which one of the internal temperature and the external temperature is indicated by the transmitted results to have reached the threshold temperature first. Then, in a case where the abnormality determination control section 13c determines that the external temperature reached the threshold temperature before the internal temperature, such a fact which serves as an evidence that a person who performs fraudulent activity burned the energy meter 10 intentionally is stored as an abnormality log in the first storage section 14.

The real time clock (RTC) 17 outputs time information indicating the present time including the year, month, day, hour, minute, and second. Since the real time clock (RTC) 17 is connected to the backup battery 18, the RTC 17 will not stop operating because of a power outage or the like, and constantly outputs the exact time information.

Since the time information provided from the real time clock (RTC) 17 is transmitted to the first control device 13, the first control device 13 recognizes the present time on the basis of the time information provided from the real time clock (RTC) 17. A second control device 24 in the security sensor 20 (described later) also acquires time information from the real time clock (RTC) 17 through the first control device 13 when the security sensor 20 starts; sets a timer (not illustrated) to the present time acquired; and recognizes the present time on the basis of the timer.

The security sensor 20 is a detection device installed on the circuit board 7 inside the housing 2, as illustrated in (a) and (b) of Fig. 2, and can be removed from the energy meter 10. The security sensor 20 is configured to detect fraudulent activity carried out for electricity theft on the energy meter 10.

As illustrated in Fig. 1, the security sensor 20 includes a radio wave sensor 21a, an electrostatic discharge (ESD) sensor 21b, a magnetic-field sensor 21c, an acceleration sensor 21d, the internal measurement-use temperature sensor 22, the external measurement-use temperature sensor 23, the second control device 24, and a second storage section 25. In this way, the energy meter 10 in the present embodiment is provided with various kinds of sensors for preventing electricity theft through a variety of fraudulent activities carried out on the energy meter 10. However, in an aspect of the present invention, the security sensor 20 need only include at least the internal measurement-use temperature sensor 22 and the external measurement-use temperature sensor 23.

As illustrated in Fig. 1, the security sensor 20 includes, in a resin package (not illustrated), the sensors excluding the external measurement-use temperature sensor 23, i.e., the radio wave sensor 21a, the electrostatic discharge (ESD) sensor 21b, the magnetic-field sensor 21c, the acceleration sensor 21d, and the internal measurement-use temperature sensor 22.

The radio wave sensor 21a outputs a sensor value AD1 correlated with the amount of radio waves in a frequency band that would cause electromagnetic interference (EMI) in an electronic device. Specifically, when radio waves are emitted to render the processor for measuring power consumption (first control device 13 in the present embodiment) inoperable, the sensor value AD1 outputted from the radio wave sensor 21a increases. Consequently, by detecting electromagnetic interference with use of the radio wave sensor 21a, it is possible to prevent electricity theft committed through electromagnetic interference. When the first control device 13 is rendered inoperable by the emission of radio waves, the first control device 13 cannot measure power consumption, thereby allowing electricity theft to take place.

The electrostatic discharge (ESD) sensor 21b outputs a sensor value AD2 corresponding to an increased amount of charge when surge takes place in the energy meter 10. Specifically, when an electrostatic discharge is induced to render the processor for measuring power consumption (first control device 13 in the present embodiment) inoperable, surge takes place in the energy meter 10, thus causing the sensor value AD2 to increase. Consequently, by detecting electrostatic discharge induced for the purpose of electricity theft with use of the electrostatic discharge (ESD) sensor 21b, it is possible to prevent electricity theft committed through electrostatic discharge. When the first control device 13 is rendered inoperable by the electrostatic discharge, the first control device 13 cannot measure power consumption, thereby allowing electricity theft to take place.

The magnetic-field sensor 21c outputs a sensor value AD3 correlated with the intensity of a magnetic field. Specifically, when the energy meter 10 is exposed to a magnetic field for the purpose of causing the current sensors CT1 and CT3 to malfunction, the sensor value AD3 outputted from the magnetic-field sensor 21 increases. Consequently, by detecting exposure to a magnetic field with use of the magnetic-field sensor 21c, it is possible to prevent electricity theft committed via exposure to a magnetic field. When the current sensors CT1 and CT3 malfunction due to exposure to a magnetic field, the current amount is not outputted normally, and thus the power amount calculating section 13a cannot measure the power amount, thereby allowing electricity theft to take place.

The acceleration sensor 21d measures a rate at which an object moves, and can detect inclination (gravity), motion, vibration and impact of an object. Specifically, when a fraudulent activity such as an impact given to the energy meter 10 with, for example, a drill is committed for the purpose of breaking the housing 2 of the energy meter 10, the sensor value AD4 outputted from the acceleration sensor 21d increases. Consequently, by detecting breakage of the energy meter 10 committed for the purpose of electricity theft with use of the acceleration sensor 21d, it is possible to prevent electricity theft committed via breakage of the energy meter 10. When the energy meter 10 is broken, the power amount cannot be measured. This allows electricity theft to take place. In addition, even in a case where, for example, a thermocouple (described later) of the external measurement-use temperature sensor 23 is extracted by a fraudster, vibration occurs. This allows the acceleration sensor 21d to detect that the external measurement-use temperature sensor 23 has been extracted.

The internal measurement-use temperature sensor 22 and the external measurement-use temperature sensor 23 measure temperatures corresponding to an internal temperature and an external temperature, respectively, of the energy meter 10, and each include, for example, a thermocouple or a resistance temperature detector. As described earlier, the internal measurement-use temperature sensor 22 in accordance with the present embodiment is housed inside the package of the security sensor 20, and measures internal temperature of the housing 2, internal temperature of the security sensor 20 in particular. Note that the internal measurement-use temperature sensor 22 does not necessarily need to be housed inside the package of the security sensor 20. Alternatively, for example, the internal measurement-use temperature sensor 22 may be, for example, exposed and fixed on the circuit board 7, rather than being housed inside the package, so that a temperature of the circuit board 7 or a temperature in the vicinity of the circuit board 7 is measured.

The internal measurement-use temperature sensor 22 is arranged at a first location which is located, for example, inside the housing 2. There is a high possibility that the origin of a fire from inside is the power supply circuit 12 on the circuit board 7. Thus, it is preferable to provide the internal measurement-use temperature sensor 22 in the vicinity of the power supply circuit 12.

As illustrated in (b) of Fig. 2, the external measurement-use temperature sensor 23 is provided not in the security sensor 20 but at a second location which is located, for example, inside the housing 2. The second location is located closer to the housing 2 than is the first location. According to the present embodiment, the external measurement-use temperature sensor 23 is provided, for example, below the display section 3 so as to be adjacent to an inner side surface of the housing 2. Therefore, the external measurement-use temperature sensor 23 detects a temperature which is closer to an external temperature of the housing 2 than is a temperature detected by the internal measurement-use temperature sensor 22. The external measurement-use temperature sensor 23 can measure a temperature of the housing 2, or can measure a temperature in the vicinity of the housing 2. The external measurement-use temperature sensor 23 can be provided so as to be adjacent to an inner side surface of the display section 3. The external measurement-use temperature sensor 23 and the housing 2 can be provided apart from each other. For example, the thermocouple of the external measurement-use temperature sensor 23 in accordance with the present embodiment is provided in a small gap between the display section 3 and the housing 2. This allows the temperature of the housing 2 of the energy meter 10 to be measured. The main body of the external measurement-use temperature sensor 23 can be located inside the housing 2, provided that the temperature to be measured by the external measurement-use temperature sensor 23 is a temperature of the housing 2 or a temperature in the vicinity of the housing 2. The "temperature of the housing 2 or the temperature in the vicinity of the housing 2" can be not only a temperature at a front side of the housing 2 but also temperatures at an upper surface, a side surface, or a lower surface of the housing 2.

Cooperation among the internal measurement-use temperature sensor 22, the external measurement-use temperature sensor 23, the second control device 24, and the second storage section 25 will be described in detail below.

### [Configuration for preventing fraudulent activity of burning energy meter for the purpose of electricity theft]

Conventionally, a fraudulent activity of willfully burning an energy meter to destroy the display section on which an accumulated power consumption is displayed and accumulated power consumption data stored in the energy meter is committed for the purpose of electricity theft. In this case, when an administrator of, for example, an electric power company which administers the energy meter, files a claim for the damage against the wrongdoer, the wrongdoer may evade compensation for the damage by arguing that a fire broke out from inside the energy meter due to current leakage or the like.

Thus, against the fraudulent activity of willfully burning an energy meter, it is important to identify that the energy meter has been burned from outside the energy meter.

(a) of Fig. 3 is a graph showing temperature changes in internal and external temperatures in the case where the energy meter has been burned from outside the energy meter. (b) of Fig. 3 is a graph showing temperature changes in internal and external temperatures in the case where a fire has broken out from inside the energy meter. In (a) and (b) of Fig. 3, a vertical axis represents a temperature (°C), and a horizontal axis represents an elapsed time (year, month, day, hour, minute). In (a) of Fig. 3, fire is set from outside at 11:42:30. Respective temperature changes in internal temperature and external temperature of an energy meter in the case where the energy meter has been burned from outside the energy meter and in the case where fire has broken out from inside the energy meter will be described on the basis of experimental results shown in (a) and (b) of Fig. 3.

As shown in (a) of Fig. 3, in a case where the energy meter 10 has been burned from outside, the external temperature of the energy meter 10 rises earlier than the internal temperature of the energy meter 10, and after that, the internal temperature sharply rises at a given point in time. This is considered to occur because the housing 2 of the energy meter 10 is burned out at the point in time when the circuit board 7 and other members provided inside the energy meter 10 catch fire, and air is sufficiently distributed throughout the inside so that the inside of the energy meter 10 is burned within a short period in time.

Specifically, at time t1 (=11:46:20), the external temperature detected by the external measurement-use temperature sensor 23 is at a threshold temperature Th which was set in advance. At time t2 (=11:47:30), the internal temperature detected by the internal measurement-use temperature sensor 22 is at a threshold temperature Th which was set in advance. In the present embodiment, the threshold temperature Th is, for example, 100°C. However, the threshold temperature Th is not necessarily 100°C and may be other temperature. In addition, the first threshold temperature of the external temperature and the second threshold temperature value of the internal temperature can be different from each other. For example, it is possible that (i) the threshold of the external temperature is 150°C and (ii) the threshold of the internal temperature is 100°C.

It is therefore understood that in a case where fire has been set to the energy meter 10 from outside, the external temperature of the energy meter 10 reaches the threshold temperature Th before does the internal temperature.

Meanwhile, as illustrated in (b) of Fig. 3, in a case where fire has broken out from inside the energy meter 10, the internal temperature is less likely to rise sharply since the energy meter 10 is sealed and the inside of the energy meter 10 is deficient in oxygen. At a stage where the housing 2 of the energy meter 10 catches fire, the external temperature rises gradually. Finally, at a stage where a hole is made to the housing 2, air (oxygen) is supplied through the hole. This causes the external temperature of the energy meter 10 to rise sharply.

Specifically, at time t3 (=12:51:50), the internal temperature detected by the internal measurement-use temperature sensor 22 is at a threshold temperature Th which was set in advance. At time t4 (=12:52:25), the external temperature detected by the external measurement-use temperature sensor 23 is at a threshold temperature Th which was set in advance. Note that the threshold temperature Th is, for example, 100°C which is a threshold temperature Th in a case where fire is set to the energy meter 10 from outside.

It is therefore understood that in a case where fire breaks out from inside the energy meter 10, the internal temperature of the energy meter 10 reaches the threshold temperature Th before does the external temperature.

Consequently, in a case where fire has been set to the energy meter 10 from outside, the external temperature of the energy meter 10 becomes equal to or higher than the threshold temperature Th first, and then the internal temperature of the energy meter 10 becomes equal to or higher than the threshold temperature Th. On the other hand, in a case where the energy meter has burned because fire has broken out from inside due to current leakage or the like, the internal temperature of the energy meter 10 becomes equal to or higher than the threshold temperature Th first, and then the external temperature of the energy meter 10 becomes equal to or higher than the threshold temperature Th.

Therefore, in a case where it can be demonstrated that the external temperature of the energy meter 10 became equal to or higher than the threshold temperature Th before the internal temperature, it is then possible to prove that the fraudulent activity of willfully burning the energy meter 10 was committed.

As such, as illustrated in Fig. 1, the energy meter 10 in accordance with the present application includes the external measurement-use temperature sensor 23 which serves as an external temperature detection sensor configured to detect the external temperature of the energy meter 10. Further, the energy meter 10 includes, in the security sensor 20, the sensor data determining section 24b which serves as a section for determining whether or not the external temperature has reached the threshold, i.e., a section configured to determine whether or not the external temperature of the energy meter 10 detected by the external measurement-use temperature sensor 23 has become equal to or higher than the threshold temperature Th set as the first threshold temperature.

The security sensor 20 further includes: the internal measurement-use temperature sensor 22 which serves as an internal temperature detection sensor configured to detect the internal temperature of the energy meter 10; and the sensor data determining section 24b which serves as a section for determining whether or not an internal temperature has reached a threshold, i.e., a section configured to determine whether or not the internal temperature of the energy meter 10 detected by the internal measurement-use temperature sensor 22 has become equal to or higher than the threshold temperature Th set as the second threshold temperature. The first threshold temperature and the second threshold temperature can be identical or different.

That is, the security sensor 20 includes the second control device 24 and the second storage section 25. The second control device 24 includes a sensor data acquiring section 24a, the sensor data determining section 24b, and the sensor data communication control section 24c.

Consequently, a temperature AD5 detected by the internal measurement-use temperature sensor 22 and a temperature AD6 detected by the external measurement-use temperature sensor 23 are transmitted to the sensor data acquiring section 24a of the second control device 24. Then, the sensor data determining section 24b determines whether or not the internal temperature of the energy meter 10 detected by the internal measurement-use temperature sensor 22 has become equal to or higher than the threshold temperature Th set as the second threshold temperature, and determines whether or not the external temperature of the energy meter 10 detected by the external measurement-use temperature sensor 23 has become equal to or higher than the threshold temperature Th set as the first threshold temperature.

The temperature AD5 detected by the internal measurement-use temperature sensor 22 and the temperature AD6 detected by the external measurement-use temperature sensor 23 are stored in the second storage section 25 as a detection log. Further, a time at which the internal temperature of the energy meter 10 detected by the internal measurement-use temperature sensor 22 has become equal to or higher than the threshold temperature Th and a time at which the external temperature of the energy meter 10 detected by the external measurement-use temperature sensor 23 has become equal to or higher than the threshold temperature Th are each acquired from the real time clock (RTC) 17 and stored in the second storage section 25 as a detection log.

In response to an instruction from the abnormality control section 13c to read out a detection log in the second storage section 25, the detection log is transmitted to the abnormality control section 13c via the sensor data communication control section 24c.

The abnormality control section 13c determines which one of the following (i) and (ii) occurred before the other on the basis of which one of the occurrences of (i) and (ii) was transmitted to the abnormality control section 13c first: (i) the external temperature of the energy meter 10 reached the threshold temperature Th and (ii) the internal temperature of the energy meter 10 became equal to or higher than the threshold temperature Th. Then, the abnormality control section 13c stores this information in the first storage section 14 as fire outbreak location information.

As illustrated in Fig. 1, the external server 30 (cause determination device) includes a determination processing section 31 serving as a presuming section, an external server storage section 32 storing an energy meter log, a receiving section 33, and an output section 34. The receiving section 33 receives electric power amount and abnormality information from the energy meter 10 and outputs the electric power amount and the abnormality information received to the determination processing section 31. The determination processing section 31 has a function of the presuming section to presume (determine) a cause of an abnormality on the basis of the electric power amount and the abnormality information transmitted from the energy meter 10. The external server 30 may be a server of a power supply company or may be a server of a monitoring center or a server of a security institution in an electricity-managed area. The output section 34 records the cause of the abnormality determined by the determination processing section 31 in the external server storage section 32 or transmits the cause to an external device. The external server storage section 32 records therein all of the electric power amount and the abnormality information transmitted from the energy meter 10.

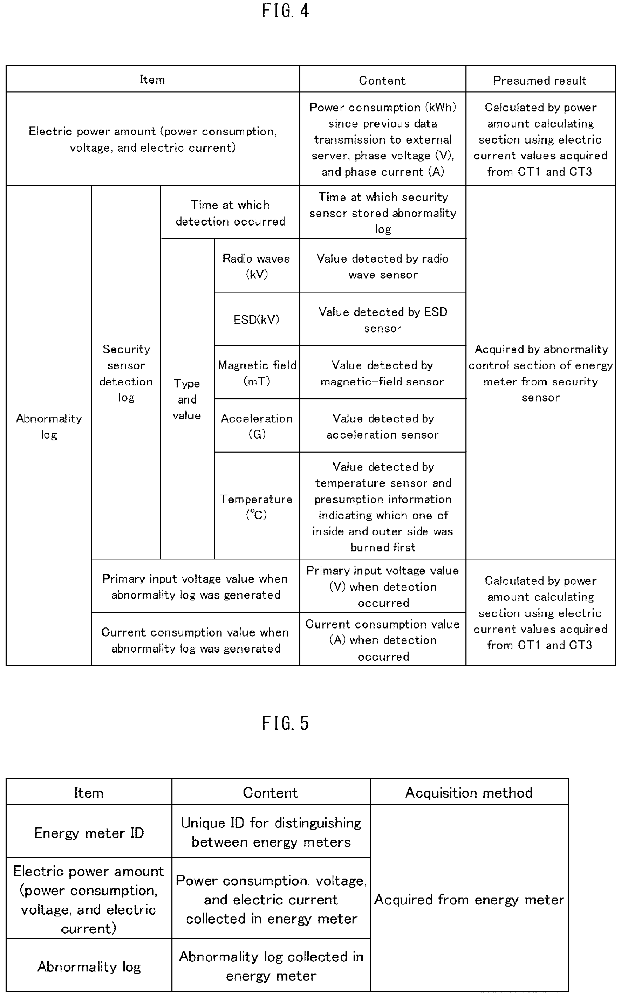

The following description will discuss, with reference to Figs. 4 through 6, a method for managing an electric power amount and a detection log in the power amount management system 1 in accordance with the present embodiment. As described above, in the power amount management system 1 in accordance with the present embodiment, data is delivered from the energy meter 10 constituted by the smart meter to the external server 30 (i.e., to a management center where electric power amounts are collected) periodically, for example, every 10 minutes to every 30 minutes. In the following description, it is assumed that the data delivery is periodically performed every 10 minutes.

As illustrated in Fig. 1, the energy meter 10 includes the first storage section 14 constituted by an EEPROM, and pieces of information collected inside the energy meter 10 are accumulated in the first storage section 14.

Fig. 4 is a view showing a list of data stored in the first storage section 14 of the energy meter 10. As shown in Fig. 4, the pieces of information collected are roughly classified into an electric power amount and an abnormality log. An electric power amount means power consumption, a voltage, and an electric current, and are represented as: power consumption (kWh) since the previous transmission of data to the external server 30; an input voltage (a phase voltage) (V); and current consumption (a phase current) (A). The power consumption (kWh) is calculated by the power amount calculating section 13a using voltage values and electric current values acquired from the voltage-dividing circuit 11 and the current sensors CT1 and CT3.

An abnormality log includes a detection log from the security sensor 20, a primary input voltage value at a time at which the abnormality log was generated (a time at which an abnormality was detected), and a current consumption value at a time at which the abnormality log was generated.

A detection log from the security sensor 20 includes: a time at which the security sensor 20 stored the abnormality log (at a time at which an abnormality was detected (a time at which a detection occurred)); a value detected by the radio wave sensor 21a (radio waves (kV)); a value detected by the electrostatic discharge (ESD) sensor 21b (ESD (kV)); a value detected by the magnetic-field sensor 21c (a magnetic field (mT)); a value detected by the acceleration sensor 21d (acceleration (G)); values detected by the internal measurement-use temperature sensor 22 and the external measurement-use temperature sensor 23 (temperatures °C); and presumption information indicative of which one of the inside and the outer side of the energy meter 10 was presumably burned first. These pieces of information can be obtained using the respective sensors in the security sensor 20 of the energy meter 10.

The primary input voltage value at the time at which the abnormality log was generated is a primary input voltage value (V) at the time at which the detection occurred, and the current consumption value at the time at which the abnormality log was generated is a current consumption value (A) at the time at which the detection occurred. These pieces of information can be calculated by the power amount calculating section 13a using electric current values acquired from the current sensors CT1 and CT3.

Data stored in the external server storage section 32 of the external server 30 includes, in addition to the above-described data, an ID for identifying each energy meter 10.

Fig. 5 is a view showing a list of data stored in the external server storage section32 of the external server 30 in the power amount management system 1. As shown in Fig. 5, the data stored in the external server storage section 32 of the external server 30 are classified into: an energy meter ID that is a unique ID for identifying each of many energy meters 10 present in a managed area; an electric power amount (power consumption, a voltage, and an electric current) which is power consumption collected in the energy meter 10; and an abnormality log collected in the energy meter 10.

Logs stored in the energy meter 10 and the external server 30 are evaluated respectively at the energy meter 10 and the external server 30 on the basis of the following evaluation criteria. This improves probability of presumption (accuracy of determination) of an abnormality.

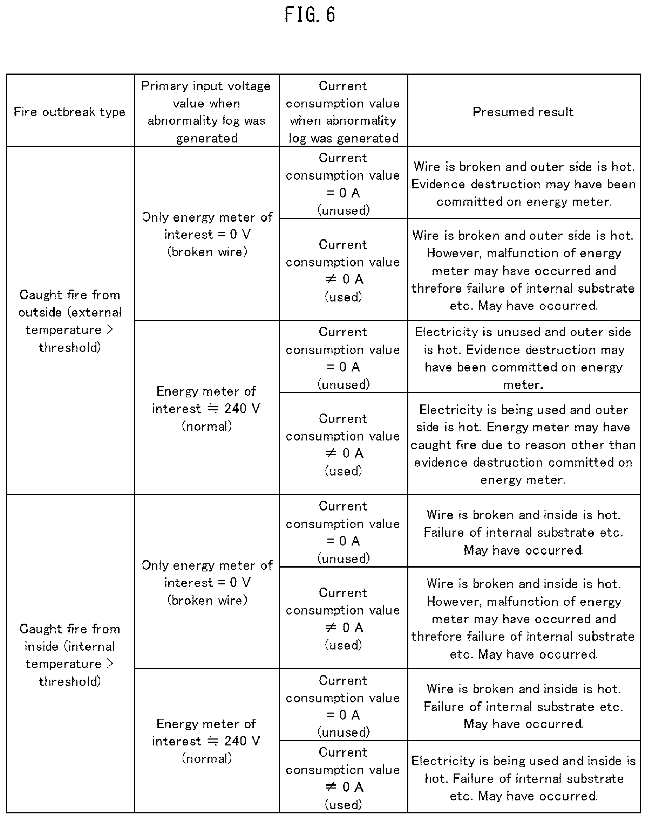

Fig. 6 is a view showing evaluation criteria in accordance with which the determination processing section 31 of the external server 30 determines an abnormality in a case where the external temperature of the energy meter 10 has exceeded the threshold temperature Th and in a case where the internal temperature of the energy meter 10 has exceeded the threshold temperature Th. As shown in Fig. 6, in a case where it is determined that the external temperature detected by the external measurement-use temperature sensor 23 has exceeded the threshold temperature Th first (in a case where an abnormality occurrence location, at which an abnormality has occurred, is the second location), the determination processing section 31 of the external server 30 presumes as follows.

First, in a case where a primary input voltage value in an energy meter 10 of interest at a time at which an abnormality log was generated is 0 (V), that is, in a case where a wire is broken, the determination processing section 31 presumes as follows.

(1) In a case where a current consumption value at the time at which the abnormality log was generated is 0 (A), that is, in a case where no electricity has been used, it follows that the energy meter 10 is in a state where "a wire is broken and the outer side of the energy meter 10 is hot." Accordingly, the determination processing section 31 presumes that destruction of evidence may have been committed (fire has been set by a wrongdoer) on the energy meter 10.
(2) In a case where a current consumption value at the time at which the abnormality log was generated is not 0 (A), that is, in a case where electricity is being used, it follows that the energy meter 10 is in a state where "a wire is broken and the outer side of the energy meter 10 is hot." However, the information that the primary input voltage value is 0 (V) and the information that the current consumption value is not 0 (A) contradict each other. As such, the determination processing section 31 presumes that malfunction of the ammeter may have occurred, and accordingly presumes that a failure of the circuit board 7 or the like may have occurred.

On the other hand, in a case where a primary input voltage value in an energy meter 10 of interest at a time at which an abnormality log was generated is approximately 240 (V), that is, in a normal state, the determination processing section 31 presumes as follows. Note that although a predetermined value of the primary input voltage value is approximately 240 (V) in the present embodiment, the predetermined value is not necessarily limited to approximately 240 (V), and can be 100 (V), 200 (V) or other values instead.

(1) In a case where a current consumption value at the time at which the abnormality log was generated is 0 (A), that is, in a case where no electricity has been used, it follows that the energy meter 10 is in a state where "no electricity is being used and the outer side of the energy meter 10 is hot." In this case, it is unlikely that the energy meter 10 caught fire from inside. Accordingly, the determination processing section 31 presumes that destruction of evidence may have been committed on the energy meter 10.
(2) In a case where a current consumption value at the time at which the abnormality log was generated is not 0 (A), that is, in a case where electricity is being used, it follows that the energy meter 10 is in a state where "electricity is being used and the outer side of the energy meter 10 is hot." Accordingly, the determination processing section 31 presumes that the energy meter 10 may have caught fire due to a reason other than destruction of evidence. This is because a wrongdoer who is going to set fire on the energy meter 10 would unplug the power cable of an electric appliance in advance, in order to prevent breaking the electric appliance.

On the other hand, in a case where it is determined that the internal temperature detected by the internal measurement-use temperature sensor 22 has exceeded the threshold temperature Th first (in a case where an abnormality occurrence location, at which an abnormality has occurred, is at the first location), the determination processing section 31 presumes as follows.

In a case where a primary input voltage value in an energy meter 10 of interest at a time at which an abnormality log was generated is 0 (V), that is, in a case where a wire is broken, the determination processing section 31 presumes as follows.

(1) In a case where a current consumption value at the time at which the abnormality log was generated is 0 (A), that is, in a case where no electricity has been used, it follows that the energy meter 10 is in a state where "a wire is broken and the inside of the energy meter 10 is hot." Accordingly, the determination processing section 31 presumes that a failure of an internal substrate or the like may have occurred or the energy meter 10 may have caught fire due to a reason other than destruction of evidence (normal fire).
(2) In a case where a current consumption value at the time at which the abnormality log was generated is not 0 (A), that is, in a case where electricity is being used, it follows that the energy meter 10 is in a state where "a wire is broken and the inside of the energy meter 10 is hot." However, the determination processing section 31 presumes that malfunction of the ammeter may have occurred, and accordingly presumes that a failure of the circuit board 7 or the like may have occurred.

On the other hand, in a case where a primary input voltage value in an energy meter 10 of interest at a time at which an abnormality log was generated is approximately 240 (V), that is, in a normal state, the determination processing section 31 presumes as follows.

(1) In a case where a current consumption value at the time at which the abnormality log was generated is 0 (A), that is, in a case where no electricity has been used, it follows that the energy meter 10 is in a state where "a wire is broken and the inside of the energy meter 10 is hot." Accordingly, the determination processing section 31 presumes that a failure of an internal substrate or the like may have occurred.
(2) In a case where a current consumption value at the time at which the abnormality log was generated is not 0 (A), that is, in a case where electricity is being used, it follows that the energy meter 10 is in a state where "electricity is being used and the inside of the energy meter 10 is hot." Accordingly, the determination processing section 31 presumes that a failure of an internal substrate or the like may have occurred.

Note that in a case where primary input voltage values in all of the energy meters 10 present in a certain area are 0 (V), it is assumed that a power outage has occurred.

The output section 34 records thus presumed (determined) cause of the abnormality in the external server storage section 32. The output section 34 may cause an alert indicative of content that varies depending on the presumed cause of the abnormality to be displayed on an external device (a display device or a speaker) connected to the external server 30. The alert may be a display or a voice indicative of the cause of the abnormality. The output section 34 may output the alert to a target that varies depending on the cause of the presumed abnormality. For example, in a case where it has been presumed that the cause of the abnormality is fire due to a reason other than destruction of evidence, the output section 34 may output an alert corresponding to the cause of the abnormality to a server of a fire department or the like in an area corresponding to the energy meter 10, thereby notifying the fire department or the like of the fire. This allows the fire department to promptly extinguish the fire. For example, in a case where it has been presumed that the cause of the abnormality is destruction of evidence, the output section 34 may output an alert corresponding to the cause of the abnormality to a server of a security center of an electric power company or of a power supply company, thereby notifying the security center of the fraudulent activity. This allows a staff member of the security center to visit the site where the fraudulent activity has taken place and promptly check the situation. In this case, in order to extinguish the fire deliberately set, the output section 34 may output an alert corresponding to the cause also to a server of a fire department or the like.

In the above description, the determination processing section 31 determines the cause of an abnormality in accordance with a combination of: a location at which the temperature has become high; a value of the primary input voltage; and a value of the current consumption, but the present embodiment is not limited to this. The determination processing section 31 may determine the cause of an abnormality in accordance with a combination of a location at which the temperature has become high and a value of current consumption. For example, in a case where the external temperature exceeds the threshold temperature and the current consumption value is 0 (A), the determination processing section 31 may presume, as shown in Fig. 6, that destruction of evidence may have been committed on the energy meter 10. For example, in a case where the external temperature exceeds the threshold temperature and the current consumption value is not 0 (A), the determination processing section 31 may presume, as shown in Fig. 6, that a failure of an internal substrate or the like may have occurred or the energy meter 10 may have caught fire due to a reason other than destruction of evidence. Similarly, the determination processing section 31 may determine the cause of the abnormality in accordance with a combination of a location at which the temperature has become high and a value of the primary input voltage.

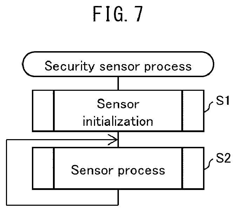

The following description will discuss, with reference to Fig. 7, an operation process of the security sensor 20 of the energy meter 10.

Fig. 7 is a flowchart of a main routine indicative of the operation process of the security sensor 20. As shown in Fig. 7, the operation process of the security sensor 20 in carrying out a process consists of two sub-routines: a sensor initialization operation and a sensor process operation.

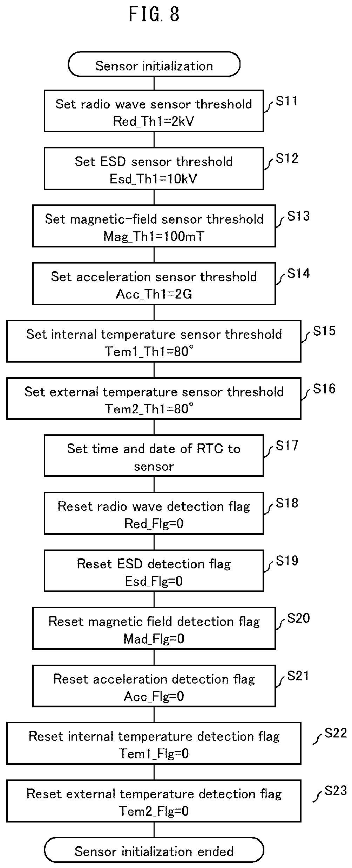

Fig. 8 is a flowchart of a sub-routine indicative of the sensor initialization operation of the security sensor 20. As shown in Fig. 8, firstly, a threshold of the radio wave sensor 21a is set (S11) in the sensor initialization operation of the security sensor 20. Specifically, for example, "radio wave sensor threshold Red_Th1 = 2 kV" is set. Subsequently, a threshold of the electrostatic discharge (ESD) sensor 21b is set (S12). Specifically, for example, "electrostatic discharge (ESD) sensor threshold ESD_Th1 = 10 kV" is set. Subsequently, a threshold of the magnetic-field sensor 21c is set (S13). Specifically, for example, "magnetic-field sensor threshold Mag_Th1 = 100 mT" is set. Subsequently, a threshold of the acceleration sensor 21d is set (S14). Specifically, for example, "acceleration sensor threshold Acc_Th1 = 2 G" is set. Subsequently, a threshold of the internal measurement-use temperature sensor 22 is set (S15). Specifically, for example, "internal measurement-use temperature sensor threshold Tem 1_Th1 = 100°C" is set. Subsequently, a threshold of the external measurement-use temperature sensor 23 is set (S16). Specifically, for example, "external measurement-use temperature sensor threshold Tem2_Th1 = 100°C" is set.

Subsequently, time and date of the real time clock (RTC) 17 is set to each sensor (S17).

Subsequently, a flag of the radio wave sensor 21a is reset (S18). Specifically, "radio wave detection flag Red_Flg = 0" is set. Subsequently, a flag of the electrostatic discharge (ESD) sensor 21b is reset (S19). Specifically, "electrostatic discharge (ESD) detection flag ESD_Flg = 0" is set. Subsequently, a flag of the magnetic-field sensor 21c is reset (S20). Specifically, "magnetic field detection flag Mag_Flg = 0" is set. Subsequently, a flag of the acceleration sensor 21d is reset (S21). Specifically, "acceleration detection flag Acc_Flg = 0" is set. Subsequently, a flag of the internal measurement-use temperature sensor 22 is reset (S22). Specifically, "internal measurement-use temperature detection flag Tem1_Rlg = 0" is set. Subsequently, a flag of the external measurement-use temperature sensor 23 is reset (S23). Specifically, "external measurement-use temperature detection flag Tem2_Flg = 0" is set. Thus, the sensor initialization operation of the security sensor 20 is ended.

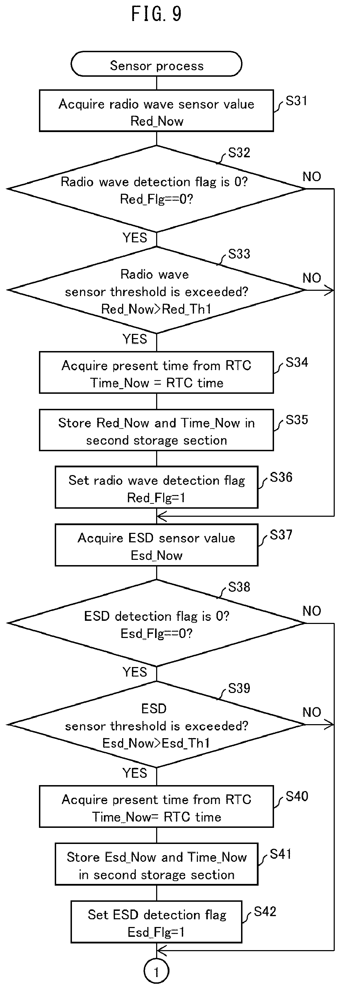

Figs. 9 through 11 are each a flowchart of a sub-routine indicative of the sensor process operation of the security sensor 20.

As shown in Fig. 9, firstly, a current value Red_Now of the radio wave sensor 21a is acquired (S31) in the sensor process operation. Subsequently, it is determined whether or not "radio wave detection flag Red_Flg = 0" is true (S32). In a case where "radio wave detection flag Red_Flg = 0" is true, it is determined whether or not the current value Red_Now of the radio wave sensor 21a has exceeded the radio wave sensor threshold Red_Th1 (S33). In a case where the current value Red_Now of the radio wave sensor 21a has exceeded the radio wave sensor threshold Red_Th1, the present time is acquired from the real time clock (RTC) 17 (S34). Specifically, "present time Time_Now = RTC time" is set. Subsequently, the current value Red_Now of the radio wave sensor 21a and the present time Time_Now are stored in the second storage section 25 constituted by a flash memory (S35). Subsequently, "radio wave detection flag Red_Flg = 1" is set (S36). Note that in a case where "radio wave detection flag Red_Flg = 0" is false at S32 and in a case where the current value Red_Now of the radio wave sensor 21a has not exceeded the radio wave sensor threshold Red_Th1 at S33, the sensor process operation jumps to the next step S37.

Subsequently, a current value ESD_Now of the electrostatic discharge (ESD) sensor 21b is acquired (S37). Subsequently, it is determined whether or not "electrostatic discharge (ESD) detection flag ESD_Flg = 0" is true (S38). In a case where "electrostatic discharge (ESD) detection flag ESD_Flg = 0" is true, it is determined whether or not the current value ESD_Now of the electrostatic discharge (ESD) sensor 21b has exceeded the electrostatic discharge (ESD) sensor threshold ESD_Th1 (S39). In a case where the current value ESD_Now of the electrostatic discharge (ESD) sensor 21b has exceeded the electrostatic discharge (ESD) sensor threshold ESD_Th1, the present time is acquired from the real time clock (RTC) 17 (S40). Specifically, "present time Time_Now = RTC time" is set. Subsequently, the current value ESD_Now of the electrostatic discharge (ESD) sensor 21b and the present time Time_Now are stored in the second storage section 25 constituted by the flash memory (S41). Subsequently, "electrostatic discharge (ESD) detection flag ESD_Flg = 1" is set (S42). Note that in a case where "electrostatic discharge (ESD) detection flag ESD_Flg = 0" is false at S38 and in a case where the current value ESD_Now of the electrostatic discharge (ESD) sensor 21b has not exceeded the electrostatic discharge (ESD) sensor threshold ESD_Th1 at S39, the sensor process operation jumps to the next step S43.

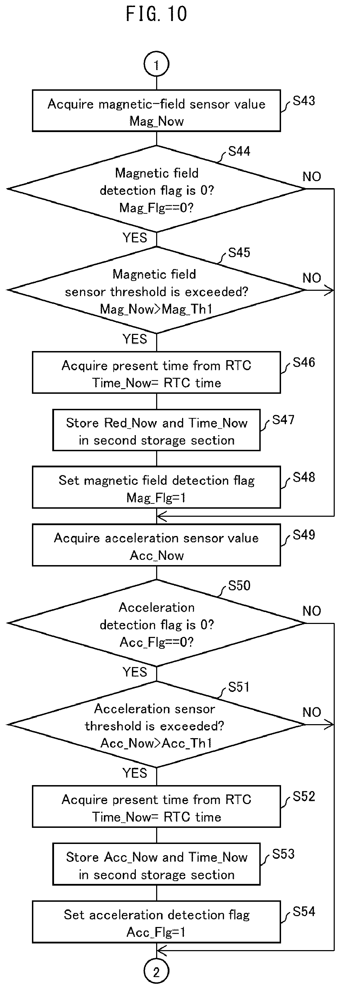

As shown in Fig. 10, subsequently, a current value Mag_Now of the magnetic-field sensor 21c is acquired (S43). Subsequently, it is determined whether or not "magnetic field detection flag Mag_Flg = 0" is true (S44). In a case where "magnetic field detection flag Mag = 0" is true, it is determined whether or not the current value Mag_Now of the magnetic-field sensor 21c has exceeded the magnetic-field sensor threshold Mag_Th1 (S45). In a case where the current value Mag_Now of the magnetic-field sensor 21c has exceeded the magnetic-field sensor threshold Mag_Th1, the present time is acquired from the real time clock (RTC) 17 (S46). Specifically, "present time Time_Now = RTC time" is set. Subsequently, the current value Mag_Now of the magnetic-field sensor 21c and the present time Time_Now are stored in the second storage section 25 constituted by the flash memory (S47). Subsequently, "magnetic field detection flag Mag_Flg = 1" is set (S48). Note that in a case where "magnetic field detection flag Mag_Flg = 0" is false at S44 and in a case where the current value Mag_Now of the magnetic-field sensor 21c has not exceeded the magnetic-field sensor threshold Mag_Th1 at S45, the sensor process operation jumps to the next step S49.

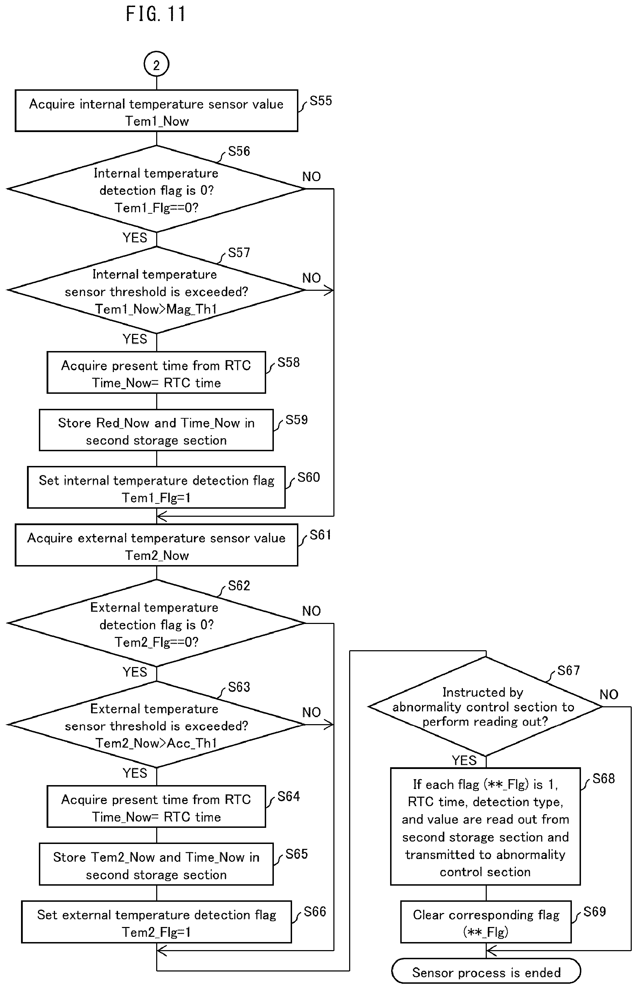

Subsequently, a current value Acc_Now of the acceleration sensor 21d is acquired (S49). Subsequently, it is determined whether or not "acceleration detection flag Acc_Flg = 0" is true (S50). In a case where "acceleration detection flag Acc_Flg = 0" is true, it is determined whether or not the current value Acc_Now of the acceleration sensor 21d has exceeded the acceleration sensor threshold Acc_Th1 (S51). In a case where the current value Acc_Now of the acceleration sensor 21d has exceeded the acceleration sensor threshold Acc_Th1, the present time is acquired from the real time clock (RTC) 17 (S52). Specifically, "present time Time_Now = RTC time" is set. Subsequently, the current value Acc_Now of the acceleration sensor 21d and the present time Time_Now are stored in the second storage section 25 constituted by the flash memory (S53). Subsequently, "acceleration detection flag Acc_Flg = 1" is set (S54). Note that in a case where "acceleration detection flag Acc_Flg = 00" is false at S50 and in a case where the current value Acc_Now of the acceleration sensor 21d has not exceeded the acceleration sensor threshold Acc_Th1 at S51, the sensor process operation jumps to the next step S55 shown in Fig. 11.

As shown in Fig. 11, subsequently, a current value Tem 1_Now of the internal measurement-use temperature sensor 22 is acquired (S55). Subsequently, it is determined whether or not "internal measurement-use temperature detection flag Tem1_Flg = 0" is true (S56). In a case where "internal measurement-use temperature detection flag Tem1_Flg = 0" is true, it is determined whether or not the current value Tem1_Now of the internal measurement-use temperature sensor 22 has exceeded the internal measurement-use temperature sensor threshold Tem1_Th1 (S57). In a case where the current value Tem1_Now of the internal measurement-use temperature sensor 22 has exceeded the internal measurement-use temperature sensor threshold Tem1_Th1, the present time is acquired from the real time clock (RTC) 17 (S58). Specifically, "present time Time_Now = RTC time" is set. Subsequently, the current value Tem1_Now of the internal measurement-use temperature sensor 22 and the present time Time_Now are stored in the second storage section 25 constituted by the flash memory (S59). Subsequently, "internal measurement-use temperature detection flag Tem1_Flg = 1" is set (S60). In a case where "internal measurement-use temperature detection flag Tem1_Flg = 00" is false at S56 and in a case where the current value Tem1_Now of the internal measurement-use temperature sensor 22 has not exceeded the internal measurement-use temperature sensor threshold Tem1_Th1 at S57, the sensor process operation jumps to the next step S61.

Subsequently, a current value Tem2_Now of the external measurement-use temperature sensor 23 is acquired (S61). Subsequently, it is determined whether or not "external measurement-use temperature detection flag Tem2_Flg = 0" is true (S62). In a case where "external measurement-use temperature detection flag Tem2_Flg = 0" is true, it is determined whether or not the current value Tem2_Now of the external measurement-use temperature sensor 23 has exceeded the external measurement-use temperature sensor threshold Tem2_Th1 (S63). In a case where the current value Tem2_Now of the external measurement-use temperature sensor 23 has exceeded the external measurement-use temperature sensor threshold Tem2_Th1, the present time is acquired from the real time clock (RTC) 17 (S64). Specifically, "present time Time_Now = RTC time" is set. Subsequently, the current value Tem2_Now of the external measurement-use temperature sensor 23 and the present time Time_Now are stored in the second storage section 25 constituted by the flash memory (S65). Subsequently, "external measurement-use temperature detection flag Tem2_Flg = 1" is set (S66). Note that in a case where "external measurement-use temperature detection flag Tem2_Flg = 0" is false at S62 and in a case where the current value Tem2_Now of the external measurement-use temperature sensor 23 has not exceeded the external measurement-use temperature sensor threshold Tem2_Th1 at S63, the sensor process operation jumps to the next step S67.

Subsequently, it is determined whether or not the abnormality control section 13c has instructed to perform reading out (S67). In a case where the abnormality control section 13c has instructed to perform reading out and the value of each flag is "1", the RTC time, the type of detection, and the current value of the flag are detected from the second storage section 25 constituted by the flash memory and are transmitted to the abnormality control section 13c (S68). Subsequently, the corresponding flag is cleared (S69). Thus, the sensor process is ended. Note that in a case where the abnormality control section 13c has not instructed to perform reading out at S67, the sensor process is immediately ended.

The following description will discuss, with reference to Fig. 12, a process of transmitting an electric power amount and an abnormality log carried out by the energy meter 10. Fig. 12 is a flowchart of a main routine indicative of an electric power amount/abnormality log transmitting process operation carried out by the energy meter 10.

As shown in Fig. 12, the energy meter 10 carries out an input voltage calculation process (S5) and a current consumption calculation process (S6) and then carries out an electric power amount calculation (S7). Then, a voltage value, an electric current value, and an electric power amount calculated and an abnormality log are transmitted to the external server 30 ordinarily by a 10-minute-interval transmission process (S9) and are transmitted to the external server 30 by an immediate transmission process (S8) in an emergency.

(a) of Fig. 13 is a flowchart of a sub-routine indicative of the 10-minute-interval transmission process carried out by the energy meter 10 to transmit an electric power amount and an abnormality log. (b) of Fig. 13 is a flowchart of a sub-routine indicative of the immediate transmission process carried out by the energy meter 10 to transmit an electric power amount and an abnormality log.

As shown in (a) of Fig. 13, firstly, an electric power amount for 10 minutes stored in the first storage section 14 constituted by the EEPROM is transmitted by the energy meter 10 to the external server 30 (S71) in the 10-minute-interval transmission process. Then, the energy meter 10 transmits to the external server 30 an input voltage and current consumption for 10 minutes stored in the first storage section 14 (S72). Then, the energy meter 10 transmits to the external server 30 a detection log of the security sensor 20 stored in the first storage section 14 (S73). Thus, the 10-minute-interval transmission process is ended.

As shown in (b) of Fig. 13, in the immediate transmission process, it is first determined whether or not an external temperature detection log of the external measurement-use temperature sensor 23 has been received from the security sensor 20 (S81). In a case where the external temperature detection log of the external measurement-use temperature sensor 23 has been received from the security sensor 20, the external temperature detection log is immediately transmitted to the external server 30 (S82). Note that in a case where no external temperature detection log of the external measurement-use temperature sensor 23 has been received from the security sensor 20 at S81, the immediate transmission process immediately jumps to the next step S82.

Subsequently, it is determined whether or not an internal temperature detection log of the internal measurement-use temperature sensor 22 has been received from the security sensor 20 (S83). In a case where the internal temperature detection log of the internal measurement-use temperature sensor 22 has been received from the security sensor 20, the internal temperature detection log is immediately transmitted to the external server 30 (S84). Thus, the immediate transmission process is ended.

Lastly, the following description will discuss, with reference to (a) and (b) of Fig. 14, a presumption method carried out by the determination processing section 31 of the external server 30. (a) of Fig. 14 is a flowchart showing a determination process carried out by the external server 30, and (b) of Fig. 14 is a view showing presumed results.

As shown in (a) and (b) of Fig. 14, the determination processing section 31 of the external server 30 first determines whether or not an external temperature log of the external measurement-use temperature sensor 23 has been received (S101). Then, in a case where the external temperature log of the external measurement-use temperature sensor 23 has been received, the determination processing section 31 determines whether or not an input voltage is 0 V (S102). Then, in a case where the input voltage is 0 V, the determination processing section 31 determines whether or not current consumption is 0 A (S103). In a case where the current consumption is 0 A at S103, the determination processing section 31 selects a result J1 according to (b) of Fig. 14 (S104). In a case where the current consumption is not 0 A at S103, the determination processing section 31 selects a result J2 according to (b) of Fig. 14 (S105).

On the other hand, in a case where the external temperature log of the external measurement-use temperature sensor 23 has been received and the input voltage is not 0 V at S102, the determination processing section 31 determines whether or not current consumption is 0 A (S106). In a case where the current consumption is 0 A at S106, the determination processing section 31 selects a result J3 according to (b) of Fig. 14 (S107). In a case where the current consumption is not 0 A at S106, the determination processing section 31 selects a result J4 according to (b) of Fig. 14 (S108).

Subsequently, the external server 30 determines whether or not an internal temperature log of the internal measurement-use temperature sensor 22 has been received (S109). Then, in a case where the internal temperature log of the internal measurement-use temperature sensor 22 has been received, the determination processing section 31 determines whether or not an input voltage is 0 V (S110). Then, in a case where the input voltage is 0 V, the determination processing section 31 determines whether or not current consumption is 0 A (S111). In a case where the current consumption is 0 A at S111, the determination processing section 31 selects a result J5 according to (b) of Fig. 14 (S112). In a case where the current consumption is not 0 A at S111, the determination processing section 31 selects a result J6 according to (b) of Fig. 14 (S113).

On the other hand, in a case where the internal temperature log of the internal measurement-use temperature sensor 22 has been received and the input voltage is not 0 V at S111, the determination processing section 31 determines whether or not current consumption is 0 A (S114). In a case where the current consumption is 0 A at S114, the determination processing section 31 selects a result J7 according to (b) of Fig. 14 (S115). In a case where the current consumption is not 0 A at S114, the determination processing section 31 selects a result J8 according to (b) of Fig. 14 (S116).

As described above, in the power amount management system 1 in accordance with the present embodiment, the energy meter 10 includes: the first storage section 14 which serves as a storage section configured to store an electric power amount and abnormality information including sensor detection information indicative of detection of occurrence of an abnormality of the energy meter; and the external communication section 16 which serves as a transmission section configured to transmit, immediately to the external server 30 when the energy meter catches fire, the electric power amount and the abnormality information stored in the first storage section 14. The external server 30 includes the determination processing section 31 which serves as a presuming section configured to presume, on the basis of the electric power amount and the abnormality information transmitted from the energy meter 10, whether or not a fraudulent activity has been committed.

This allows an administrator to presume, with use of the determination processing section 31 on the basis of the electric power amount and the abnormality information transmitted from the energy meter 10 to the external server 30, whether or not a fraudulent activity has been committed. In particular, in the power amount management system 1 in accordance with the present embodiment, the electric power amount and the abnormality information stored in the first storage section 14 are transmitted by the external communication section 16 of the energy meter 10 immediately when the energy meter 10 catches fire. As such, in a case where fire is set on the energy meter 10, the electric power amount and the abnormality information stored in the first storage section 14 of the energy meter 10 are immediately transmitted to the external server 30 when the energy meter 10 catches fire. As a result, the external server 30 can reliably receive the electric power amount and the abnormality information stored in the first storage section 14 of the energy meter 10 without losing the electric power amount and the abnormality information.

Thus, it is possible to provide the power amount management system 1 which can transmit the electric power amount and the abnormality information including sensor detection information to the external server 30 before the energy meter 10 is burned down in a case where fire has been set to the energy meter 10.

Further, in the power amount management system 1 in accordance with the present embodiment, the energy meter 10 includes: the external measurement-use temperature sensor 23 which serves as an external temperature detection sensor configured to detect whether or not the external temperature of the energy meter 10 has become equal to or higher than the threshold temperature Th set as the first threshold temperature; and the internal measurement-use temperature sensor 22 which serves as an internal temperature detection sensor configured to detect whether or not the internal temperature of the energy meter 10 has become equal to or higher than the threshold temperature Th set as the second threshold temperature. The sensor detection information includes fire outbreak location information indicative of which one of the following (i) and (ii) occurred before the other: (i) the external temperature of the energy meter 10 became equal to or higher than the threshold temperature Th and (ii) the internal temperature of the energy meter 10 became equal to or higher than the threshold temperature Th.

In a case where fire is set to the energy meter 10, the external temperature of the energy meter 10 becomes equal to or higher than the threshold temperature Th first, and then the internal temperature of the energy meter 10 becomes equal to or higher than the threshold temperature Th. On the other hand, in a case where the energy meter 10 burns because fire has broken out from inside due to current leakage or the like, the internal temperature of the energy meter 10 becomes equal to or higher than the threshold temperature Th first, and then the external temperature of the energy meter 10 becomes equal to or higher than the threshold temperature Th.

Therefore, in a case where it can be demonstrated that the external temperature of the energy meter 10 became equal to or higher than the threshold temperature Th before the internal temperature, it is then possible to prove that the fraudulent activity of willfully burning the energy meter 10 was committed.

As such, in the present embodiment, the external measurement-use temperature sensor 23 and the internal measurement-use temperature sensor 22 are provided. The first storage section 14 stores therein, as abnormality information, fire outbreak location information indicative of which one of the following (i) and (ii) occurred before the other: (i) the external temperature of the energy meter 10 became equal to or higher than the threshold temperature Th and (ii) the internal temperature of the energy meter 10 became equal to or higher than the threshold temperature Th. The fire outbreak location information is transmitted from the external communication section 16 to the external server 30 when the energy meter 10 catches fire. Thus, the fire outbreak location information can be specifically identified.

In the power amount management system 1 in accordance with the present embodiment, the energy meter 10 immediately transmits the electric power amount and the abnormality information to the external server 30, considering the following (i) or (ii) as a timing when the energy meter 10 has caught fire: (i) when the external temperature of the embodiment has become equal to or higher than the threshold temperature Th set as the first threshold temperature or (ii) when the internal temperature of the energy meter 10 has become equal to or higher than the threshold temperature Th set as the second threshold temperature.

This allows specifying which one of the following (i) and (ii) is the timing when the energy meter 10 caught fire: (i) the external temperature of the energy meter 10 became equal to or higher than the threshold temperature Th and (ii) the internal temperature of the energy meter 10 became equal to or higher than the threshold temperature Th.

In the power amount management system 1 in accordance with the present embodiment, the sensor detection information includes sensor detection information of at least one of the radio wave sensor 21a, the electrostatic discharge (ESD) sensor 21b, the magnetic-field sensor 21c, and the acceleration sensor 21d.

Thus, the radio wave sensor 21a, the electrostatic discharge (ESD) sensor 21b, the magnetic-field sensor 21c, and the acceleration sensor 21d are adopted as various sensor detection information for detecting an occurrence of an abnormality of the energy meter 10. This allows detecting, with use of the radio wave sensor 21a or the electrostatic discharge (ESD) sensor 21b, whether or not radio wave emissions or an electrostatic discharge has been created to render the power amount calculating section 13a (i.e., a processor for measuring power consumption) inoperable. It also becomes possible to detect, with use of the magnetic-field sensor 21c, whether or not the energy meter 10 has been exposed to a magnetic field for the purpose of causing the current sensors CT1 and CT3 to malfunction. It also becomes possible to detect, with use of the acceleration sensor 21d, whether or not breakage of the energy meter 10 has been committed using an impact or the like.

The external server 30 in accordance with the present embodiment is used in the power amount management system 1. Thus, it is possible to provide the external server 30 which is used in the power amount management system 1 which can transmit the electric power amount and the abnormality information including sensor detection information to the external server 30 before the energy meter 10 is burned down in a case where fire has been set to the energy meter 10.

Note that in the power amount management system 1 in accordance with the present embodiment, presumption of the cause of an abnormality is carried out by the external server 30. However, the present embodiment is not necessarily limited to this. For example, the energy meter 10 may presume the cause of an abnormality in a similar manner.

The present invention is not limited to the description of the embodiments above, but may be altered by a skilled person within the scope of the claims.

### Reference Signs List

1: Power amount management system
3: Display section
7: Circuit board
10: Energy meter
13: First control device
13a: Power amount calculating section
13b: Display control section
13c: Abnormality control section
14: First storage section (storage section)
16: External communication section (transmitting section)
20: Security sensor
21a: Radio wave sensor
21b: Electrostatic discharge (ESD) sensor
21c: Magnetic-field sensor
21d: Acceleration sensor
22: Internal measurement-use temperature sensor (internal temperature detection sensor)
23: External measurement-use temperature sensor (external temperature detection sensor)
24: Second control device
24a: Sensor data acquiring section
24b: Sensor data determining section
24c: Sensor data communication control section
25: Second storage section
30: External server (cause determination device)
31: Determination processing section (presuming section)
32: External server storage section
CT1, CT3: Current sensor
Th: Threshold temperature (first threshold temperature, second threshold temperature, temperature threshold)

## Claims

1. A device (30) enabling the determination of the cause of a fire of an energy meter (10), the device being configured to:
receive, from the energy meter (10), (i) information of a temperature at each of a plurality of locations of the energy meter (10) and (ii) information of current consumption of the energy meter (10),
wherein the plurality of locations includes a first location inside the energy meter (10) and a second location located closer to a housing of the energy meter (10) than is the first location;
determine whether or not a cause of occurrence of a fire of the energy meter (10) is a fraudulent activity, in accordance with a combination of (i) a fire occurrence location at which a temperature has exceeded a temperature threshold corresponding to the fire occurrence location among the plurality of locations and (ii) a value of the current consumption,
wherein the cause of occurrence of the fire is determined to be a fraudulent activity in a case where a temperature of the second location has exceeded the temperature threshold before a temperature of the first location exceeds the temperature threshold, and the current consumption is zero; and
output the cause determined.

2. The device (30) as set forth in claim 1, configured to output an alert that varies depending on the cause.

3. The device (30) as set forth in claim 2, configured to output the alert to a target that varies depending on the cause.

4. A power amount management system comprising:
a device (30) enabling the determination of the cause of a fire as set forth in any one of claims 1 through 3; and
the energy meter (10) configured to transmit, to the device (30), (i) information of a temperature at each of a plurality of locations of the energy meter (10) and (ii) information of the current consumption of the energy meter (10).

5. A method enabling the determination of the cause of a fire of an energy meter (10), the method comprising the steps of:
receiving, from the energy meter (10), (i) information of a temperature at each of a plurality of locations of the energy meter (10) and (ii) information of current consumption of the energy meter (10),
wherein the plurality of locations includes a first location inside the energy meter (10) and a second location located closer to a housing of the energy meter (10) than is the first location; and
determining whether or not a cause of occurrence of a fire of the energy meter (10) is a fraudulent activity, in accordance with a combination of (i) a fire occurrence location at which a temperature has exceeded a temperature threshold corresponding to the fire occurrence location among the plurality of locations and (ii) a value of the current consumption,
wherein the cause of occurrence of the fire is determined to be a fraudulent activity in a case where a temperature of the second location has exceeded the temperature threshold before a temperature of the first location exceeds the temperature threshold, and the current consumption is zero.

## Patentansprüche

1. Vorrichtung (30) zur Ermöglichung der Bestimmung der Ursache eines Brandes eines Energiemessgeräts (10), wobei die Vorrichtung eingerichtet ist,
von dem Energiemessgerät (10) (i) Informationen über eine Temperatur an jeder von einer Vielzahl von Positionen des Energiemessgeräts (10) und (ii) Informationen über einen Stromverbrauch des Energiemessgeräts (10) zu empfangen,
wobei die Vielzahl von Positionen eine erste Position innerhalb des Energiemessgeräts (10) und eine zweite Position, die näher an einem Gehäuse des Energiemessgeräts (10) liegt als die erste Position, umfasst;
zu bestimmen, ob eine Ursache für das Auftreten eines Brandes des Energiemessgeräts (10) eine betrügerische Handlung ist, entsprechend einer Kombination aus (i) einer Brandentstehungsposition, bei der eine Temperatur den der Brandentstehungsposition entsprechenden Temperaturschwellenwert unter der Vielzahl von Positionen überschritten hat, und (ii) einem Wert des Stromverbrauchs,
wobei die Ursache des Auftretens des Brandes als betrügerische Handlung bestimmt wird, wenn eine Temperatur der zweiten Position den Temperaturschwellenwert überschritten hat, bevor eine Temperatur der ersten Position den Temperaturschwellenwert überschreitet, und der Stromverbrauch null ist; und
die bestimmte Ursache auszugeben.

2. Vorrichtung (30) nach Anspruch 1, wobei die Vorrichtung eingerichtet ist, einen Alarm auszugeben, der je nach der Ursache variiert.

3. Vorrichtung (30) nach Anspruch 2, wobei die Vorrichtung eingerichtet ist, den Alarm an ein Ziel auszugeben, das je nach der Ursache variiert.

4. Leistungsmanagementsystem, umfassend:
eine Vorrichtung (30) zur Ermöglichung der Bestimmung der Ursache eines Brandes nach einem der Ansprüche 1 bis 3; und
das Energiemessgerät (10), das eingerichtet ist, an die Vorrichtung (30) (i) Informationen über eine Temperatur an jeder von einer Vielzahl von Positionen des Energiemessgeräts (10) und (ii) Informationen über einen Stromverbrauch des Energiemessgeräts (10) zu übertragen.

5. Verfahren zur Ermöglichung der Bestimmung der Ursache eines Brandes eines Energiemessgeräts (10), wobei das Verfahren die folgenden Schritte umfasst:
Empfangen von dem Energiemessgerät (10) (i) Informationen über eine Temperatur an jeder von einer Vielzahl von Positionen des Energiemessgeräts (10) und (ii) Informationen über einen Stromverbrauch des Energiemessgeräts (10),
wobei die Vielzahl von Positionen eine erste Position innerhalb des Energiemessgeräts (10) und eine zweite Position, die näher an einem Gehäuse des Energiemessgeräts (10) liegt als die erste Position, umfasst; und
zu bestimmen, ob eine Ursache für das Auftreten eines Brandes des Energiemessgeräts (10) eine betrügerische Handlung ist, entsprechend einer Kombination aus (i) einer Brandentstehungsposition, bei der eine Temperatur den der Brandentstehungsposition entsprechenden Temperaturschwellenwert unter der Vielzahl von Positionen überschritten hat, und (ii) einem Wert des Stromverbrauchs,
wobei die Ursache des Auftretens des Brandes als betrügerische Handlung bestimmt wird, wenn eine Temperatur der zweiten Position den Temperaturschwellenwert überschritten hat, bevor eine Temperatur der ersten Position den Temperaturschwellenwert überschreitet, und der Stromverbrauch null ist.

## Revendications

1. Dispositif (30) permettant de déterminer la cause d'un incendie d'un compteur d'énergie (10), le dispositif étant configuré pour :
recevoir, à partir du compteur d'énergie (10), (i) des informations relatives à une température en chacun d'une pluralité d'emplacements du compteur d'énergie (10) et (ii) des informations relatives à une consommation de courant du compteur d'énergie (10),
la pluralité d'emplacements comprenant un premier emplacement à l'intérieur du compteur d'énergie (10) et un deuxième emplacement situé plus près d'un boîtier du compteur d'énergie (10) que ne l'est le premier emplacement ;
déterminer si une cause de survenue d'un incendie du compteur d'énergie (10) est ou non une activité frauduleuse, en fonction d'une combinaison de (i) un emplacement de survenue de l'incendie auquel une température a dépassé un seuil de température correspondant à l'emplacement de survenue de l'incendie parmi la pluralité d'emplacements et (ii) une valeur de la consommation de courant,
la cause de survenue de l'incendie étant déterminée comme étant une activité frauduleuse dans un cas où une température du deuxième emplacement a dépassé le seuil de température avant qu'une température du premier emplacement ne dépasse le seuil de température, et où la consommation de courant est nulle ;
fournir en sortie la cause déterminée.

2. Dispositif (30) selon la revendication 1, configuré pour fournir en sortie une alerte qui varie en fonction de la cause.

3. Dispositif (30) selon la revendication 2, configuré pour fournir en sortie l'alerte à une cible qui varie en fonction de la cause.

4. Système de gestion de quantité d'énergie, comprenant :
un dispositif (30) permettant de déterminer la cause d'un incendie selon l'une quelconque des revendications 1 à 3 ; et
le compteur d'énergie (10) configuré pour transmettre, au dispositif (30), (i) des informations relatives à une température en chacun d'une pluralité d'emplacements du compteur d'énergie (10) et (ii) des informations relatives à la consommation de courant du compteur d'énergie (10).

5. Procédé permettant de déterminer la cause d'un incendie d'un compteur d'énergie (10), le procédé comprenant les étapes consistant à :
recevoir, à partir du compteur d'énergie (10), (i) des informations relatives à une température en chacun d'une pluralité d'emplacements du compteur d'énergie (10) et (ii) des informations relatives à une consommation de courant du compteur d'énergie (10),
la pluralité d'emplacements comprenant un premier emplacement à l'intérieur du compteur d'énergie (10) et un deuxième emplacement situé plus près d'un boîtier du compteur d'énergie (10) que ne l'est le premier emplacement ; et
déterminer si une cause de survenue d'un incendie du compteur d'énergie (10) est ou non une activité frauduleuse, en fonction d'une combinaison de (i) un emplacement de survenue de l'incendie auquel une température a dépassé un seuil de température correspondant à l'emplacement de survenue de l'incendie parmi la pluralité d'emplacements et (ii) une valeur de la consommation de courant,
la cause de survenue de l'incendie étant déterminée comme étant une activité frauduleuse dans un cas où une température du deuxième emplacement a dépassé le seuil de température avant qu'une température du premier emplacement ne dépasse le seuil de température, et où la consommation de courant est nulle.
